# EUROPEAN PATENT APPLICATION

(11) **EP 3 029 721 A1**
(43) Date of publication of application: **08.06.2016**
(21) Application number: 15196961.5
(22) Date of filing: 30.11.2015
(51) Int. Cl.: H01L 21/67, H01L 21/673

(54) **WAFER BOAT AND USE THEREOF**

(30) Priority: 02.12.2014 NL 2013904
(71) Applicant: Tempress IP B.V., 8171 MD Vaassen (NL)
(72) Inventor: KOLK, Barteld, 7908 LC Hoogeveen (NL); LUCHIES, Johannes Reinder Marc, 5581 GJ Waalre (NL)
(74) Representative: Nollen, Maarten Dirk-Johan

(57) **Abstract**

The wafer boat (1) is designed for purging of pressure and or liquid into purge channels defined along rods (16, 18) extending through spacers (31, 32) and provided with closing means (34, 35). The wafer boat (1) is preferably used in combination with a purge tool (100) suitable for use in a container (110) to be filled with cleaning liquid. The purge tool (100) is provided with connectors (150) and distribution means among which reservoirs (114) and channels (112). Therewith purging liquid or purging pressure may be applied to the purge channels within the wafer boat (1) via access holes located for communication with ends of rods (16, 18) of the wafer boat (1). The wafer boat (1) can be inserted into and removed from the tool (100) by means of suitable means, for instance a lever (120).

## Description

### Field of the invention

The invention relates to a wafer boat comprising
- a plurality of first and second electrically conductive plates that are arranged spaced apart in alternating order, each of which plates is provided with holes and with an extension provided with an extension hole;
- a plurality of electrically insulating rods arranged through said first and second plates, on which rods electrically insulating spacers are present for separating adjacent plates;
- a first rod arranged through the extension holes of the first plates and provided with electrically conductive spacers separating and contacting adjacent extensions of the first plates, and
- a second rod arranged through the extension holes of the second plates and provided with electrically conductive spacers separating and contacting adjacent extensions of the second plates. The invention also relates to the assembly of the wafer boat.

The invention further relates to the use of the wafer boat, including the cleaning of the wafer boat.

### Background of the invention

Wafer boats are used for transporting substrates into and out of processing equipment, such as ovens, doping chambers and chemical vapour deposition apparatus. The substrates processed therein are typically semiconductor substrates, but may also be of another material, such as ceramic substrates. The wafer boats are typically designed so that a plurality of substrates can be processed simultaneously. Moreover, the construction of the wafer boat is such that the entire substrate will be exposed to the processing.

In one typical type, the wafer boat comprises electrically conductive plates that are arranged for operation as electrodes. The plates are subdivided into first and second plates that are arranged alternatingly, most suitably in an interdigitated pattern, and which are coupled to different voltages. One substrate to be processed is then arranged between a first and a second plate, so that a voltage difference can be set over the substrate. This type of wafer boat is particularly used for plasma processing, such as plasma-enhanced chemical vapour deposition (PECVD). The electrically conductive plates contain graphite. The electrically insulating rods and spacers are preferably made of a ceramic material. Particularly, use is made of a material that has a coefficient of thermal expansion that is similar if not substantially identical to that of the material of the plates, i.e. graphite. One suitable ceramic material is for instance aluminium oxide.

A major disadvantage of current wafer boats is the cleaning. During the deposition of the substrates, the boat gets coated with the deposited material as well. After many process runs, the boat needs to be cleaned to maintain optimal process conditions for processing. The cleaning is typically carried out with wet-chemical etching means, such as an acidic aqueous solution, for instance a HF solution. After the treatment with etching means, the boat is typically rinsed with water and dried.

One way of cleaning the wafer boat involves dismantling the entire boat and clean the electrically conductive parts and the electrically insulating parts separately. This allows the best possible cleaning of the boat, but it is time-consuming and prone to error, since the parts easily break. Furthermore, the boat needs to be reassembled with very tight specifications to allow automated handling of substrates into the boat.

An alternative way of cleaning the wafer boat involves submerging the boat into an aqueous acidic solution in its entirety and subsequently rinsing it in water. A disadvantage hereof is that gaps and cavities between parts of the boat may be filled with the acidic aqueous solution due to capillary suction. This tends to lead to faster degradation, particularly of the ceramic parts in the boat.

One way of counteracting this fast degradation due to remaining acid (HF) in capillaries in the boat, resides in the provision of slits to the spacers. The provision of these slits extending through the spacers results in the reduction of dead volumes, in which conventionally no or no substantial flow occurs and therefore depositions may remain. Additional holes extending in a direction perpendicular to said slits are provided so as to avoid the accumulation of liquid.

However, a disadvantage is that the slits and holes also significantly enlarge the surface area of the boat, and hence the area where material may deposit and areas that need to be cleaned, and to be dried.

### Summary of the invention

It is therefore an object of the invention to provide an improved wafer boat, that allows a more effective cleaning, particularly without the need to dismantle the wafer boat.

According to a first aspect, the invention thereto provides a wafer boat comprising: (1) a plurality of first and second electrically conductive plates that are arranged spaced apart in alternating order, each of which plates is provided with holes and with an extension provided with an extension hole; (2) a plurality of electrically insulating rods arranged through said first and second plates, on which rods electrically insulating spacers are present for separating adjacent plates; (3) a first rod arranged through the extension holes of the first plates and provided with electrically conductive spacers separating and contacting adjacent extensions of the first plates; (4) a second rod arranged through the extension holes of the second plates and provided with electrically conductive spacers separating and contacting adjacent extensions of the second plates. According to the invention, purge channels are defined that extend through the holes and/or extension holes and the spacers parallel to the corresponding rods.

According to a second aspect, the invention provides a method of assembly of a wafer boat comprising the steps of (1) Providing a plurality of first and second electrically conductive plates, each of which plates is provided with holes and with an extension provided with an extension hole; (2) providing electrically insulating rods and a first and a second rod; (3) assembling the plates onto the rods, wherein the rods pass through the holes and the first and second rod pass through the extension hole in the extension of respectively the first and the second plates, and wherein conductive spacers are applied on the rods between the plates. Herein, purge channels are created upon assembly of the rods, plates and spacers, said purge channels extending parallel to rods between the within the holes and/or extension holes.

According to a third aspect, the invention provides a rod for use in the system and the method of the invention, which rod is provided with at least one flattened surface and one or more contact surfaces for contact to an inner surface of holes in electrically conductive plates for use in a wafer boat.

According to a fourth aspect, the invention relates to the use of the wafer boat of the invention in the processing of substrates, particularly for transport in and out of a processing equipment, and in addition to regular cleaning, which is particularly subjecting the boat to a wet-chemical treatment following by rinsing, without dismantling the boat.

According to a fifth aspect, the invention relates to a tool for purging the wafer boat of the invention during cleaning, comprising (1) a holding frame for holding the wafer boat; (2) access holes configured for cooperation with ends of rods of the wafer boat; (3) at least one connector for applying purging means, such as a tube coupled to a pump, and (4) distribution means for distribution of purging pressure and/or rinsing liquid from a connector to a first set of the access holes.

According to the invention, the wafer boat is provided with purge channels. Herewith the accumulation of the aqueous acidic solution in cavities and capillaries within the wafer boat may be counteracted or even prevented. This is achieved in that the purging may be used for applying counterpressure, therewith creating resistance against the inflow of the aqueous acidic solution into the capillaries and cavities within the wafer boat. Such a resistance is expected to limit the inflow of the aqueous acidic solution close to the outside surface of the wafer boat. Moreover, if accumulation of aqueous acidic solution would nevertheless occur, or if the purging is not applied during treatment with the aqueous acidic solution, the solution may be driven out actively, i.e. by purging.

The purge channels are suitably applied along all the rods in the wafer boat, this both the electrically insulating rods and the first and second rods through the extensions. However, this is not deemed necessary. Since the electrically insulating material of the rods is more sensitive to the aqueous acidic solution (i.e. HF solution) than the electrically conductive material (graphite), the purge channels could be arranged along the electrically insulating rods only. Furthermore, it is not necessary that all electrically insulating rods have the same design or the same exposure to the aqueous acidic solution. For this reason, it is not deemed necessary that purge channels are present along all electrically insulating rods, even though this is deemed preferable.

In one suitable embodiment, the wafer boat further comprises release channels extending from purge channels to or towards an outside surface of the boat. These release channels are preferably defined between a plate and a spacer and/or between an extension to a plate and a conductive spacer. Such release channels reduce the distance between the purge channels and the outside surface, and are thus effective to bring any fluid, such as aqueous acidic solution or rinse liquid (water or an aqueous solution with neutral pH or optionally lightly alkaline (pH7-9)) to the outside. The release channels need not to extend to the outside surface of the wafer boat. Preferably, they do not, since this would facilitate the entrance of the aqueous acidic solution into the interior of the boat. In fact, it is understood that purging pressure will be sufficient to drive fluid (liquid or gas) out, particularly through capillaries, voids and the like between a plate and a spacer, or even through any micro-channels existing within a material.

Preferably, the purge channel is defined by modification of the shape of the rod. A rod typically has a substantially cylindrical shape. According to one preferred embodiment, the rod is provided with a flattened surface. More preferably, the cylindrical rod is flattened on more than one side, to create several flattened surface, for instance 2, 3 or 4 flattened surfaces. This way of creating a purge channel is deemed advantageous over a purge channel circumferential to the rod, in that it allows to have contact surfaces for contact between the rod and the plates and suitably also the spacers. It is further deemed beneficial over a channel largely within the rod. A flattened surface does not need to be fully planar. It could also have a curvature that is less convex than that of a corresponding cylinder. However, a substantially planar shape may be useful, in view of manufacturing and so as to keep the surface of the rod that is exposed to the purge channel as small as possible.

Alternatively, the purge channel may be defined by modification of the shape and diameter of the holes and/or extension holes in the plates and in the spacers. For instance, in one specific implementation, the shape of the holes and/or extension holes in the plate may be varied, while the diameter of the holes in the spacers is modified, i.e. enlarged. The variation of the shape of the rod is herein an additional option.

In one specific embodiment, purge channel interconnects are present, between a first and a second purge channel (that extend axially along as rod). Such a purge channel interconnect is used as a connection between the first and the second purge channel. The purge channel interconnect is preferably arranged as a cavity in the rod, i.e. an area with a reduced diameter. The purge channel interconnect is suitably arranged at a distance from a plate, thus particularly at an axial location to be covered by a spacer.

In again a further embodiment, the wafer boat is provided with a main zone having at least one purge channel, an end zone provided with fixation means, such as a screw thread, and a transition zone between the main zone and the end zone with a cross-sectional area that is reduced in comparison to the main zone. In this manner, the risk of fracture close to the end zone is reduced. It is well known that fractures occur most frequently just beyond the end zone, particularly with rod having a screw thread in an end zone. By creating a transition zone with higher elasticity, such risk of fracture is reduced. This is enabled in combination with the invention, in that the modification of the main zone of the rod anyhow leads to a modified shape, such that the difference in (average) diameter is reduced. Particularly, the diameter of the rod in the transition zone corresponds, at the side of the end zone and at least largely, to a core diameter of the screw thread. The cross-sectional diameter of the rod in the transition zone is suitably substantially circular.

In one embodiment, the wafer boat is further provided with a purging slot extending in the transition zone and the end zone for introducing purging pressure and/or rinsing liquid. This purging slot is more particularly a channel defined into the rod, or at a surface of the rod. Such a purging slot enables the provision of sufficient purging pressure and/or rinsing liquid into the purge channel. Alternative embodiments, such as an aperture through a screw or an aperture within the rod are not excluded. Additionally, means for purging and/or means for supplying rinsing liquid may be present. These means are suitably embodied as an entrance for the liquid or purging fluid and/or as a connector. For instance, a screw typically present at an end of the rod may be redesigned as a connector to allow that a tube, access holes or such means can be properly connected thereto.

The wafer boat of the invention is particularly suitable for cleaning by means of an aqueous acidic solution without the need for dismantling the boat. Most suitably, the aqueous acidic solution is a HF solution, as is known to the skilled person. An alternative is a solution of acetic acid, for instance vinegar. It is not excluded that the aqueous acid solution contains additives and/or is a mixture of several acids. Suitably, the wafer boat is rinsed with rinsing liquid after the treatment with the aqueous acidic solution. It may then be dried, though this is not deemed strictly necessary, since drying may occur in the course of preparation of any processing. Tests have shown that the internal rinsing of the wafer boat after cleaning the boat with an aqueous acidic solution may significantly reduce the amount of aqueous acidic solution, for instance by a factor of 10-50. Furthermore, when low pressurized water (or any other aqueous solution) is applied into the purging channels of the boat prior to submerging the boat in a bath of cleaning liquid, and the boat is rinsed with rinsing liquid through the purging channels, the amount of aqueous acidic solution may be reduced even more dramatically, for instance with a factor of more than 100, or even more than 500, for instance 1000. It was furthermore found in preliminary tests that the rinsing liquid can easily be pushed out of the purging channels. A limited pressure difference, for instance 0.02-0.3 bar, turns out enough to ensure an outgoing stream of water, which does not exclude that higher pressures may be used. It will be understood that the pressure differences needed may further depend on the dimensions of the boat and the purging channels. Furthermore, a wafer boat may be dried entirely (also inside) by supplying dry air, for instance during 30 minutes at a 2 bar pressure.

In a most suitable embodiment, use is made of a tool for purging the wafer boat, comprising a holding frame for holding the wafer boat; access holes configured for cooperation with ends of rods of the wafer boat; at least one connector for applying purging means, such as a tube coupled to a pump, and distribution means for distribution of purging pressure and/or rinsing liquid from a connector to a first set of the access holes. This tool will ensure a connection of the ends of the rods to purging means. Its holding frame is herein suitably used to distribute the purging pressure via the first set of the access holes in to the corresponding purging channels.

The tool may have more than one connector, and there may be more than one set of access holes. Suitably, the tool is provided with a first connector internally coupled to the first set of access holes, and a second connector internally coupled to the second set of the access holes, wherein said first and second access holes are located for cooperation with opposed ends of rods of the wafer boat. In a further embodiment, the tool may be provided with separate connectors to apply purging pressure in the form of a gas (such as air, nitrogen etc) and to apply rinsing liquid, such as any type of water (demineralised water, an aqueous solution comprising some additives as solutes, a mixture of water and an alcohol for better drying, etc).

The access holes are preferably defining in a wall that is part of the holding frame. More particularly, the wall is a hollow structure. The entire holding frame may be a hollow structure, but this is a matter of mere construction and design.

The distribution means are suitably embodied in an inside of the holding frame, for ease of operation. The distribution means may contain any storage vessel to create a local source of overpressure, and/or underpressure. One possible implementation is with a venturi pump. Suitably the holding frame is also provided with suction means, for suction of any liquid, particularly aqueous acidic solution that may be present between the access holes and the purging channels.

Most suitably, the holding structure is arranged for placement into a bath of liquid, such as a bath of aqueous acidic solution. This simplifies processing such the wafer boat does not need to be moved to a further location for the purging. Moreover, and more importantly, the purging may be carried out simultaneously with the treatment with the aqueous acidic solution. Therewith, entrance of aqueous acidic solution into cavities and capillaries within the wafer boat may be limited or even substantially prevented. In a further implementation thereof, the access holes may be provided with closing means for closing the access holes. In this manner, it may be - at least substantially - prevented that the aqueous acidic solution enters the holding structure. The closing means are for instance a valve, a shutter etc.

In one important embodiment, at least one wall of the holding frame that carries the first set of access holes is movable. It is more particularly movable between a first opened position in which a boat can be placed into the holding frame, and a second closed position in which the boat is fixed by the holding frame and the access holes are arranged around the ends of rods of the wafer boat. In this manner, the holding frame may be positioned around the boat and the access holes may be positioned to cooperate with the ends of the rods with minimum mechanical handling. In one implementation such handling is embodied as automated handling, so as to minimize the risk of damage to the wafer boat. However, that is not deemed essential. The operation of moving may be a translation, a rotation or a combination thereof. It is not necessary that the movement starts at one first position and terminates at the second position. Rather, there may be several first starting positions. Preferably, the positioning of the holding frame around the boat is achieved by means of clamping.

Suitably a lever is present for effecting the movement from the first to the second position. A lever has the advantage of being simple and being least sensitive to the corrosive power of an aqueous acidic solution. More preferably, thereto, the tool comprises, at least its outside that may be exposed to said solution, an engineering plastic. Examples include a polyolefin, PET, polyvinylchloride. A polyolefin, such as polypropylene or a glass reinforced polyolefin seem fine. The tool may be provided at its outside with a suitable protection coating for protection against the aqueous acidic solution.

### Brief introduction to the figures

These and other aspects of the invention will be further elucidated with reference to the Figures, in which:
Fig. 1 shows in a bird's eye perspective a wafer boat;
Fig. 2 shows a wafer boat according to a first embodiment of the invention in a cross-sectional view through the extensions of the first and second plates;
Fig. 3 shows in more detail a portion of Fig. 2 after rotation;
Fig. 3a shows a detail of Fig. 3;
Fig. 4 shows in more detail a portion of Fig. 2;
Fig. 5 shows a view of a rod for use in the wafer boat, and
Fig 6 shows in a bird's eye perspective a purging tool;
Fig 7 shows in a bird's eye perspective a purging tool with boat;
Fig. 8 is a sectional view corresponding to the view of Fig. 7.

### Detailed description of illustrated embodiments

The figures are not drawn to scale and merely diagrammatical in nature. Equal reference numerals in different figures refer to identical or corresponding features.

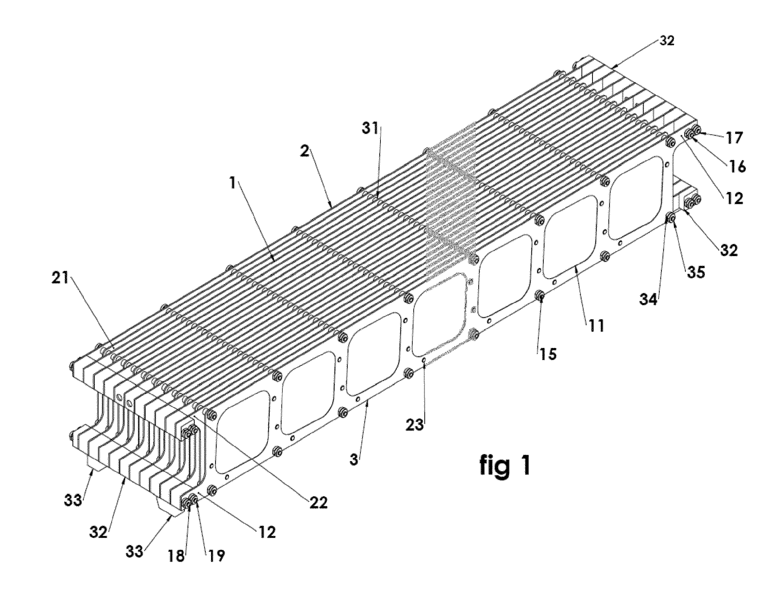

Fig. 1 shows in a bird eye's perspective a wafer boat 1 with the rods and spacers shown separately. The shown overview is known in the art. The wafer boat comprises a plurality of first plates 11 and second plates 21, which are spaced apart by means of spacers 31. The plates are provided with holes. In the present embodiment there are eight holes 13 in a row. The plates 11, 21 comprise holes close to their upper sides 2 and close to their bottom sides 3. Electrically insulating rods 15 are present to pass the holes in the plates 11, 21 and in the spacers 31, which are also provided with holes. The rods have a first end A and an opposed second end B. In order to fixate the rods 15, a nut 34 and a securing nut 35 are present at their ends A, B. As is known to the skilled person, the plates 11,21 are typically provided with windows. Such window is however closed in the outermost plate 11.

Extensions 12, 22 extend from the first plate 11 and the second plate 21 respectively. The first plate 11 and the second plate 12 each have an extension at the upper side 2 and an extension at the bottom side 3. However, this is merely one suitable implementation.. Importantly, a separation is achieved between the first and second extensions 12, 22. The first plates 11 may thus be electrically connected with each other by means of the first extensions 12 and conductive spacers 32. Similarly, the second plates 12 may be electrically connected by means of the second connections 22 and conductive spacers. In this manner, a pattern of interdigitated, mutually spaced electrodes is formed. A voltage difference may be applied between the electrodes, i.e. the first and second plates 11,21. This is deemed a particularly useful method for generating a plasma around the substrates (also known as wafers) to be positioned in the boat between a first and an adjacent second plate. The spacers 32 are connected to the first extensions 12 with first rod 16 and auxiliary rod 17. Further spacers are connected to the second extensions 22 with second rod 18 and auxiliary rod 19. In this embodiment, the first and second rod 16, 18 are electrically conductive and the auxiliary rods 17, 19 are electrically insulating. This is deemed suitable, but not essential. The boat is supported by a support element 33 that extends from said conductive spacers at the bottom side 3. Additionally, a support pin 23 is present for supporting the wafers.

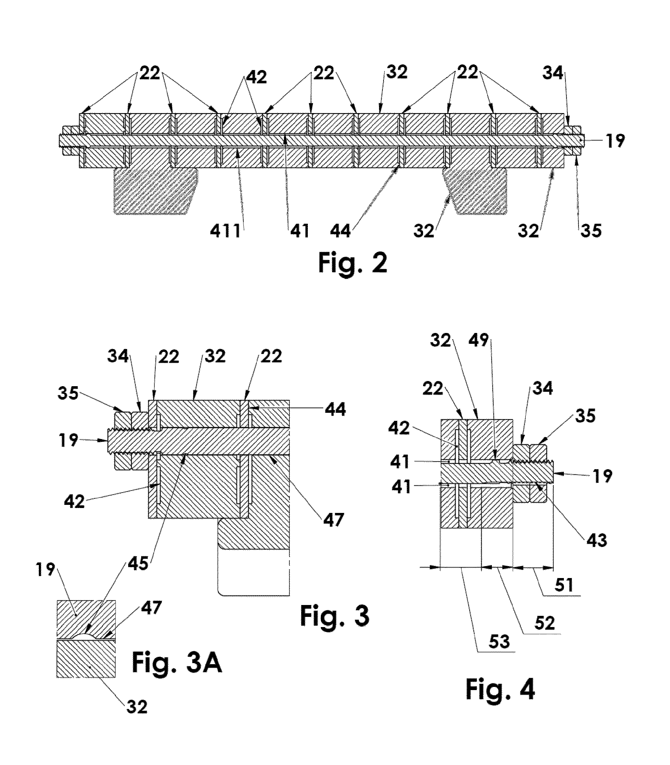

Fig. 2 shows a cross-sectional view of a boat according to the invention through second extensions 22 along the auxiliary rod 19. Fig. 3 and Fig. 4 show details hereof. While the invention is thus illustrated and explained with reference to an auxiliary rod 19, this is not essential. In accordance with one preferred embodiment of the invention, all purge channels 41 as shown in this Fig. 2 are present along all electrically insulating rods 15, 17, 19. Purge channels 41 may further be present along conductive rods 16, 18.

As shown in this Fig. 2 a rod 19 runs through a series of second extensions 22 and spacers 32. It is fixated at an end with fixation means, in this embodiment a nut 34 and a securing nut 35. A first purge channel 41 runs along the rod 19 through the assembly of plates 22 and spacers 32. In this view, an additional purge channel 411 is shown as well. It is deemed most preferable, that there are four purge channels along a single rod 19. It is furthermore preferred that all purge channels 41, 411 run substantially through said assembly. However, variations are not excluded. For instance, shorter purge channels could be mutually interconnected so as to create a network of purge channels. That may be beneficial for distribution of the purge pressure and/or for constructional stability.

Fig. 2 furthermore shows release channels 42, which extend in a direction normal to the axial direction of the rod 19 and the purge channels 41, 411. In this embodiment, the release channels 42 are slits between the plates 22 and the spacers 32. They are for instance created in the spacers 32. It is not necessary that the release channels 42 extend circumferential to the rod 19. Rather, the release channels 42 may be designed as a set of radially extending channels, with optional side channels for further distribution of the purge pressure and/or rinsing liquid.

In accordance with the invention, pressure is purged into the purge channels 41, 411. The purging pressure may enter, in one implementation, through purge slots 43 as shown in Fig. 4. Though preferred, there may be other ways of providing the purge pressure into the purge channels 41, 411. The pressure then is distributed through the release channels 42, so as to extend towards the outside of the wafer boat. The gas or liquid generating the pressure will then enter cavities and capillaries 44, so as to be liberated. The ease thereof will depend on the construction, age and material quality of the plates and spacers used in the wafer boat. The generated pressure may prevent the entrance of liquid from the outside of the boat, such as an aqueous acidic solution, for instance an HF solution in a concentration of 5-10 wt%. The generated pressure may alternatively drive out any HF solution that has been accumulated in the cavities and capillaries.

Preferably, the pressure created in the purge channels 41, 411 and the release channels 42 is sensed by a pressure sensor and on the basis thereof controlled. Such a pressure sensor will not be integrated into the wafer boat, as it is unlikely to survive the high temperature during processing, such as during plasma-enhanced chemical vapour deposition.

Fig. 3 shows a detail of Fig. 2, however in a rotated view. Fig. 3a is an enlargement of a portion of Fig. 3 and shows the purge channel interconnect 45 in more detail. In this view, purge channels 41, 411 are not visible. Rather, the rod 19 and the spacer 32 and the plates 22 are in contact along a contact surface 47. Locally, the contact surface 47 is interrupted to form a purge channel interconnect 45, that interconnects the first and the second purge channels 41, 411. The number of purge channel interconnects 45 may be set as desired, in line with any further implementation.

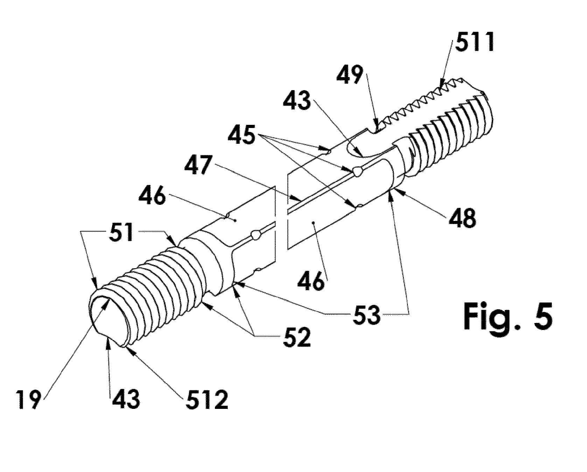

Fig. 4 shows again a detail of Fig. 2 which indicates in more detail how the purge pressure may be applied into the purge channels 41, 411. This is achieved, in the shown embodiment, by means of a purge slot 43 extending at the surface of the rod 19 in the end zone 51 and the transition zone 52. The purge slot 43 is a slot or cavity that passes the screw 511 (see Fig. 5). It then ends into the purge channel 411. By means of the purge channel interconnects 45 as shown in Fig. 3, the purging pressure may then be transmitted into other purge channels 41. The additional benefit of a purge slot 43, rather than an extension of the purge channel 411, is that the smaller diameter reduces the stiffness of the rod 19 in the transition zone 52 between the end zone 51 with the screw and the main zone 53 with the purge channel. Therewith the risk of fracture is reduced. It is observed that a purge slot 43 could be applied at one end of a rod 19 only rather than on both ends.

Fig. 5 shows a rod 19 for use in the wafer boat of the invention, in a diagrammatical view.. The rod 19 comprises different features in its end zone 51, its transition zone 52 and its main zone 53, of which in this Fig. 5 part has been omitted for sake of simplicity.

The rod 19 is provided with a screw thread 511 in its end zones 51. The diameter of this screw thread gradually decreases from the transition zone up to its ultimate ends 512. Such gradual decrease ensures that the nut 34 and securing nut 35 (see Fig. 1-4) will be fixed appropriately. Additionally, the rod is provided with a purge slot 43. In this purge slot 43, a portion of the screw thread 511 is removed. The purge slot 43 extends from the end zone 53 into the main zone 53.

The rod 19 comprises in the transition zone 52 an end portion 48 and a ring-shaped portion 49. The end portion 48 will be present- after assembly - present in a hole of a spacer 32 or a plate 12, 2. This end portion 48 is likely hidden behind nut 34. The end portion 48 is largely cylindrical in shape, so as to provide a good fit with the holes in which it is to be assembled. It is however interrupted by the purge slot 43. The ring-shaped portion 49 has a smaller diameter and is somewhat more elastic as a consequence thereof. This tends to reduce risk of fracture.

In its main zone 53, the rod 19 is provided with purge channel interconnects 45, flattened surfaces 46 and contact faces 47. Purge channel interconnects 45 that interrupt contact surfaces 47 are clearly visible. The contact surfaces 47 are present between flattened surfaces 46, which are substantially planar in the embodiment shown in Fig. 5. The flattened surfaces 46 are generated by material removal from the rod 19 that initially had a cylindrical shape. The space between a flattened surface 46 and inner surfaces of holes of the plates and spacers (as shown in Fig. 1-4) defines the purge channel.

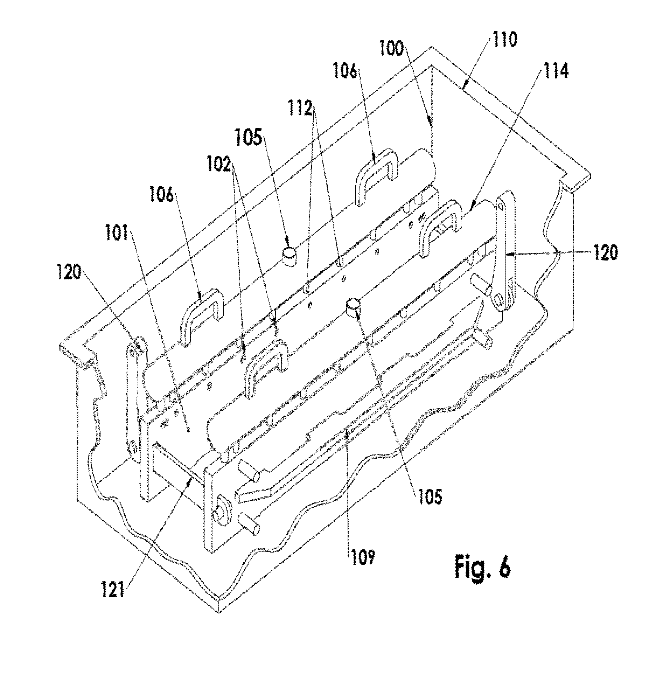

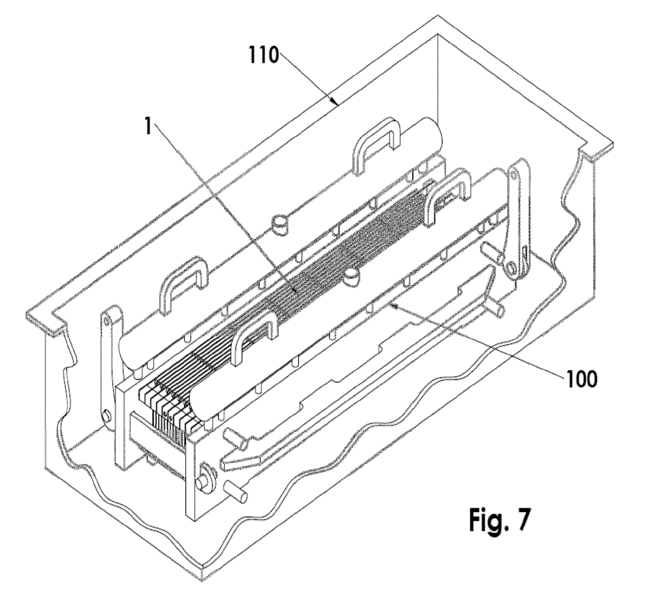

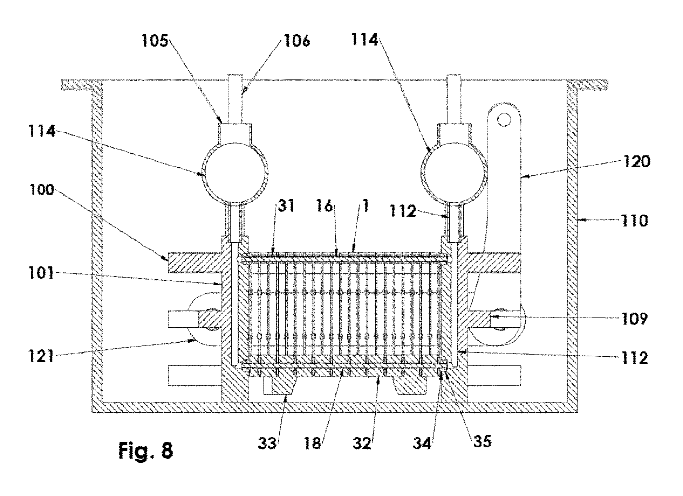

Fig. 6 shows in a bird eye's perspective a purging tool 100 that is located in a container 110 to be filled with an aqueous acidic solution for a cleaning treatment of a wafer boat. The purging tool 100 facilitates the provision of purging pressure into the wafer boat of the invention. More particularly, the shown embodiment of the purging tool 100 allows providing such purging pressure, while the wafer boat 1 will be present in the bath with aqueous acidic solution, or optionally a bath with an alternative cleaning liquid. Fig. 7 shows in a bird eye's perspective a purging tool 100 with a wafer boat 1 that is located in a container 110. The view of Fig. 7 corresponds to that of Fig. 6, but with the wafer boat 1. Fig. 8 schematically shows a side view of the wafer boat 1 as present in the purging tool 100.

The tool 100 comprises herein two walls 101 mutually connected with connecting parts 121. A bottom part could be present but is preferably left out, so as to hinder the flow of aqueous acidic solution the least possible. These elements jointly constitute a holding frame. Stiffening elements 109 may be provided if necessary. Grips 106 are defined on top of the walls 101 that are suitable for gripping the tool 100 in and out of the container 110. Suitably, the container is filled to such extend that the grips 106 will remain dry. Connectors 105 are present for supply of purging liquid and/or purging pressure, and are suitably located at an upper side of the tool. The connectors 105 are designed in this embodiment as a coupling to a tube, which is again not essential and open to change if so desired or needed.

Any purging pressure or liquid applied into the connectors 105 is then distributed to access holes 102 via distribution means. In the shown embodiment, the distribution means comprises channels 112 defined in the interior of the holding frame. This distribution is most clearly shown in the cross-sectional view of Fig. 8. A container 114 for the purging liquid is shown. When filled with liquid, it tends to create a liquid pressure automatically resulting in purging pressure.

The number of access holes 102 may be changed if so desired. In the shown embodiment, a first wall 101 comprises a first set of access holes 102. A second wall with a second set of access holes is arranged so that the access holes of the first and the second set constitute pairs. Upon assembly of a wafer boat 1 into the tool 100, a pair of access holes 102 will be located at opposed ends of a rod 15-19 (as shown in Fig. 1). Herewith, pressure and/or cleaning liquid such as water may be applied from two sides. It is furthermore feasible that one side is used as a supply of cleaning liquid whereas the other side is used as a supply of pressure. Furthermore, one side could be used for supply and the other for removal, for instance of cleaning liquid. It will be understood that any valve or other means necessary are suitably implemented as part of the tubes or other means to be connected to the connectors 105. However, a two sided access to the purge channels is not deemed necessary, most particularly not when used for purging pressure. When the purging of the channels with liquid is desired, any vapour or gas initially present is preferably removed. Therefore, a two-sided access to the purge channels is deemed a most adequate implementation, but alternatively implementations are not excluded. In one alternative design, the first set of access holes is configured to match the boat's rods and purge channels that are located in an upper row, while the second set of access holes is configured to match the rods and purge channels in a lower row.

The tool 100 further comprises a lever 120. In fact, a first and a second lever 120 are shown. Operation of the lever 120 results in movement of the wall 101. Therewith the wall may be moved from a closed location in which the access holes 102 are arranged around ends of rods of the wafer boat 1 to an opened location in which the wafer boat 1 may be put into and/or moved out of the container 110 and the purging tool 100. Fig. 7 shows the wafer boat 1 present and to be locked between the walls 101 in their closed location.

Thus, in summary, the invention provides a wafer boat (1) that is designed for purging of pressure and or liquid into purge channels defined along rods (16, 18) extending through spacers (31, 32) and provided with closing means (34, 35). The wafer boat (1) is preferably used in combination with a purge tool (100) suitable for use in a container (110) to be filled with cleaning liquid. The purge tool (100) is provided with connectors (150) and distribution means among which reservoirs (114) and channels (112). Therewith purging liquid or purging pressure may be applied to the purge channels within the wafer boat (1) via access holes located for communication with ends of rods (16, 18) of the wafer boat (1). The wafer boat (1) can be inserted into and removed from the tool (100) by means of suitable means, for instance a lever (120).

## Claims

1. A wafer boat comprising:
- a plurality of first and second electrically conductive plates that are arranged spaced apart in alternating order, each of which plates is provided with holes and with an extension provided with an extension hole;
- a plurality of electrically insulating rods arranged through said first and second plates, on which rods electrically insulating spacers are present for separating adjacent plates;
- a first rod arranged through the extension holes of the first plates and provided with electrically conductive spacers separating and contacting adjacent extensions of the first plates;
- a second rod arranged through the extension holes of the second plates and provided with electrically conductive spacers separating and contacting adjacent extensions of the second plates, wherein
- purge channels are defined that extend through the holes and/or extension holes and the spacers parallel to the corresponding rods.

2. The wafer boat as claimed in Claim 1, further comprising release channels extending from purge channels to or towards an outside surface of the boat, said release channels being particularly defined between a plate and a spacer and/or between an extension to a plate and a conductive spacer.

3. The wafer boat as claimed in Claim 1, wherein the rod adjacent to a purge channel has a flattened surface.

4. The wafer boat as claimed in Claim 1 or 3, wherein a first and a second purge channel are defined adjacent to a single rod.

5. The wafer boat as claimed in Claim 4, wherein a purge channel interconnect is defined on or through the rod.

6. The wafer boat as claimed in any of the preceding claims, wherein the rod adjacent to a purge channel is provided with a contact surface for contacting an inner surface of the hole of the plate or extension hole of the extension to the plate.

7. The wafer boat as claimed in any of the preceding claims, wherein the rod is provided with:
- a main zone having at least one purge channel
- an end zone provided with fixation means, such as a screw thread
- a transition zone between the main zone and the end zone with a cross-sectional area that is reduced in comparison to the main zone,
wherein the end zone preferably has a first core diameter and wherein the transition zone has a diameter that gradually increases from said first core diameter to a diameter of the main zone.

8. A method of assembly of a wafer boat comprising the steps of
- Providing a plurality of first and second electrically conductive plates, each of which plates is provided with holes and with an extension provided with an extension hole;
- Providing electrically insulating rods and a first and a second rod;
- Assembling the plates onto the rods, wherein the rods pass through the holes and the first and second rod pass through the extension hole in the extension of respectively the first and the second plates, and wherein conductive spacers are applied on the rods between the plates,
Wherein purge channels are created upon assembly of the rods, plates and spacers, said purge channels extending parallel to rods between the within the holes and/or extension holes.

9. The method as claimed in Claim 8, wherein use is made of rods having at least one flattened surface and one or more contact surfaces for contact to an inner surface of the holes and extension holes respectively.

10. A rod for use in the system as claimed in any of the claims 1-7 and/or the method as claimed in claim 8-9, provided with at least one flattened surface and one or more contact surfaces for contact to an inner surface of holes in electrically conductive plates for use in a wafer boat, which rod preferably having a first and a second flattened surface that are mutually separated through a contact surface, and having a cavity in said contact surface, said cavity acting in use as a purge channel interconnect.

11. Use of the wafer boat as claimed in any of the claims 1-7 for carrying substrates, particularly for transport to and from and use in a chemical vapour deposition apparatus, for instance using the tool as claimed in claim 14 or 15.

12. Use as claimed in Claim 11, further comprising the step of cleaning the wafer boat, the cleaning being preferably carried out with a wet-chemical etching means.

13. Use as claimed in Claim 11 or 12, wherein the cleaning comprises the step of purging liquid out of the boat by means of purge channels and/or rinsing by supplying rising fluid, particularly rinsing liquid, through the purge channels.

14. A tool for purging the wafer boat as claimed in any of the claims 1-7 during cleaning, comprising:
- A holding frame for holding the wafer boat;
- Access holes configured for cooperation with ends of rods of the wafer boat;
- At least one connector for applying purging means, such as a tube coupled to a pump;
- Distribution means for distribution of purging pressure and/or rinsing liquid from a connector to a first set of the access holes.

15. The tool as claimed in Claim 14, wherein the holding frame comprises a wall comprising the access holes, which wall preferably is movable between a first opened position in which a boat can be placed into the holding frame, and a second closed position in which the boat is fixed by the holding frame and the access holes are arranged around the ends of rods of the wafer boat.
